# EUROPÄISCHE PATENTSCHRIFT

(11) **EP 3 062 100 B1**
(45) Veröffentlichungstag und Bekanntmachung des Hinweises auf die Patenterteilung: **18.07.2018**
(21) Anmeldenummer: 15000558.5
(22) Anmeldetag: 26.02.2015
(51) Int. Cl.: G05G 9/047, G06F 3/0338, H01H 25/00, H01H 36/00, H01H 5/02, H01H 3/50

(54) **Sensorvorrichtung**
Sensor device
Dispositif de détection

(43) Veröffentlichungstag der Anmeldung: 31.08.2016
(73) Patentinhaber: Schlatter Industries AG, 8952 Schlieren (CH)
(72) Erfinder: Siegrist, Roger, 5524 Niederwil (CH)
(74) Vertreter: Keller & Partner Patentanwälte AG

(56) Entgegenhaltungen:
- EP-A2- 0 093 566
- US-A- 2 656 714
- US-B1- 6 265 870
- US-B2- 8 274 276

## Beschreibung

### Technisches Gebiet

Die Erfindung betrifft eine Sensorvorrichtung zur Erfassung von ferromagnetischen Werkstücken in einem Detektionsbereich in einer Schweissanlage, insbesondere zur Erfassung von Gitterdrähten. Sie betrifft weiter ein Sensorsystem zur Erfassung von ferromagnetischen Werkstücken, eine Schweissanlage mit einer Sensorvorrichtung zur Erfassung von ferromagnetischen Werkstücken, ein Verfahren zur Sollpositionsüberwachung von ferromagnetischen Werkstücken in einem Detektionsbereich sowie die Verwendung einer erfindungsgemässen Sensorvorrichtung oder eines Sensorsystems zur Erfassung von Werkstücken in einer ferromagnetischen Schweissanlage, alles gemäss den Oberbegriffen der unabhängigen Ansprüche.

### Stand der Technik

In Schweissanlagen ist das Erfassen von zu verschweissenden Gegenständen unmittelbar vor dem Zustellen der Pressen und Verschweissen eine zentrale Voraussetzung zur schnellen und prozesssicheren Produktion. Die üblicherweise angewendete elektrische Potentialüberwachung ist bei engen Platzverhältnissen und grossen Mengen anfallender Schweissspritzer wenig robust. Die an den Magneten klebenden Schweissspritzer machen Kontakt zu den Elektroden und sind somit nicht mehr potentialfrei, was eine Detektion der Gegenstände verunmöglicht. Ganz besonders viele und grosse Spritzer fallen während der Verarbeitung von galvanisiertem Draht an. Bei der Erfassung der Werkstücke erschwerend ist zudem, dass das Verfahren sehr robust gegenüber elektromagnetischen Störungen sein muss. Für dieses Patent relevante Dokumente des Standes der Technik sind EP0093566, US2656714, US6265870 und US8274276.

### Darstellung der Erfindung

Aufgabe der Erfindung ist es, eine dem eingangs genannten technischen Gebiet zugehörende Sensorvorrichtung zu schaffen, welche eine zuverlässige und robuste Erfassung von ferromagnetischen Werkstücken in einer Schweissanlage ermöglicht.

Die Lösung der Aufgabe ist durch die kennzeichnenden Merkmale der unabhängigen Ansprüche definiert. Gemäss der Erfindung umfasst die Sensoranordnung mindestens zwei durch den Magnetfelderzeuger entgegengesetzt polarisierte Polplatten. Diese Polplatten führen zur Erhöhung der magnetischen Flussdichte im Detektionsbereich.

Der Detektionsbereich kann im Rahmen der Erfindung als der Bereich definiert sein, in welchem die Anwesenheit des ferromagnetischen Werkstücks erfasst werden soll und in welchem seine Anwesenheit eine Magnetfeldänderung verursacht, welche durch den Magnetfeldsensor sicher erfasst werden kann.

Die Polplatten können bevorzugt so angeordnet sein, dass sie mit dem Magnetfelderzeuger einen magnetischen Kreis zu bilden vermögen, welcher sich über einen Luftspalt zwischen den mindestens zwei entgegengesetzt polarisierten Polplatten schliesst. Bei Anwesenheit des ferromagnetischen Werkstücks im Detektionsbereich würde sich der magnetische Kreis auch über das ferromagnetische Werkstück schliessen.

Durch die im Vergleich zu Luft höhere relative Permeabilität der ferromagnetischen Polplatten kann bei einer gewissen durch den Magnetfelderzeuger generierten Feldstärke der magnetische Fluss im Magnetkreis bei einer Anordnung mit Polplatten deutlich grösser sein als bei einer Anordnung ohne Polplatten. Gleichzeitig kann der magnetische Fluss durch die Polplatten im Detektionsbereich konzentriert werden. Die erfindungsgemässe Anordnung kann dadurch deutlich unempfindlicher gegenüber elektromagnetischen Störfeldern sein. Als weiterer Vorteil kann durch die Verwendung der Polplatten sowohl der Magnetfeldsensor als auch der Felderzeuger weiter entfernt vom Detektionsbereich und somit auch vom Schweissprozess platziert werden. Damit wäre insbesondere der Magnetfeldsensor nicht unmittelbar den Störungen ausgesetzt, welche sich bei einer Schweissbearbeitung ergeben, wie beispielsweise bei elektromagnetischen Feldern durch Schweissströme oder hohen Temperaturen.

Ein weiterer Vorteil der Erfindung ist es, dass die Sensorvorrichtung auch während des Schweissvorgangs nicht vom Werkstück wegbewegt werden muss.

Unter dem Begriff "Polplatten" können in einer bevorzugten Ausführungsform im Rahmen dieser Erfindung massive Körper aus einem ferromagnetischen Material mit einer hohen Permeabilität verstanden werden. Die Körper können eine beliebige Form aufweisen, sind bevorzugt aber massive Körper aus einem ferromagnetischen Material, welche im magnetisierten Zustand in der Nähe des Detektionsbereichs ausgeprägte Pole aufweisen, wie zum Beispiel auch Polschenkel oder Polschuhe. In einer besonders bevorzugten Ausführungsform sind die Polplatten in der Tat plattenförmig ausgelegt. Dies kann dadurch bewerkstelligt werden, dass die Polplatten eine insgesamt flächige Ausdehnung mit einer definierten Dickenausdehnung aufweisen. In einer weiteren bevorzugten Ausführungsform sind genau zwei Polplatten vorgesehen welche in ihrer flächigen Ausdehnung parallel angeordnet sind, so dass die Flächen der Polplatten im Wesentlichen parallel zueinander stehen.

Zusammenfassend kann gesagt werden, dass durch die erfindungsgemässe Sensorvorrichtung eine zuverlässige Erfassung von Werkstücken mittels Magnetfelderreger und Magnetfeldsensor möglich ist, durch welche, dank eines geringen Wartungsaufwandes, über einen grossen Zeitraum störungsfrei produzieren werden kann.

In einer weiteren bevorzugten Ausführungsform umfassen die Polplatten eine erste und eine zweite durch den Magnetfelderzeuger zueinander entgegengesetzt polarisierte Polplatte. Die erste und die zweite Polplatte weisen jeweils eine Stirnfläche auf, welche zum Detektionsbereich gerichtet und zum Detektionsbereich benachbart ist. Die Stirnflächen sind dabei in einer gemeinsamen Ebene angeordnet. Vorzugsweise grenzen die Stirnflächen der Polplatten auch unmittelbar an den Detektionsbereich an.

Die Polplatten sind vorzugsweise so magnetisiert, dass ein erster Pol des Magnetfelderzeugers an der ersten Polplatte und ein zweiter Pol des Magnetfelderzeugers an der zweiten Polplatte anliegt, so dass die Polplatten entgegengesetzt zueinander magnetisiert sind, wobei der Magnetfelderzeuger zweipolig ausgebildet ist. Mit anderen Worten, die Polplatten sind besonders bevorzugt gegenpolig magnetisiert.

Unter dem Begriff gemeinsame Ebene wird im Sinne der vorliegenden Erfindung verstanden, dass die Stirnflächen zu einer gemeinsamen Bezugsebene im mathematischen Sinne im Wesentlichen ausgerichtet sind. Die Stirnflächen sind dann auf einer gemeinsamen Ebene im Wesentlichen ausgerichtet, wenn sie sich in einem gewissen Toleranzfeld in Bezug auf diese Ebene befinden. Dieses Toleranzfeld erstreckt sich von der Bezugsebene ausgehend gleichmässig zu gleichen Teilen, so dass das Toleranzfeld durch einen prismatischen Körper beschrieben werden kann. Die Höhe des prismatischen Körpers, der das Toleranzfeld beschreibt, beträgt bevorzugter Weise 2mm, in einer weiteren bevorzugten Weise 1mm, in einer weiteren bevorzugten Weise 0.5 mm sowie in weiteren bevorzugten Weise 0.25 mm.

Die Stirnflächen können selbst Unebenheiten aufweisen, beispielsweise funktionelle Bombierungen oder Oberflächenstrukturen wie Welligkeiten. Ebenso können die Stirnflächen kleine Neigungen von wenigen Winkelgraden zur Bezugsebene haben. Bei den Abweichungen von der Bezugsebene kann es sich ebenso auch um fertigungsbedingte Abweichungen handeln. Die Stirnflächen befinden sich folglich im Rahmen dieses Toleranzfeldes auf gleicher Höhe und sind beide in Richtung des Detektionsbereich ausgerichtet.

In einer besonderen Ausführungsform ist ein Luftspalt zwischen den zwei Polplatten vorgesehen. In dieser Ausführungsform schliesst sich der vom Magnetfelderzeuger generierte magnetische Fluss über diesen Luftspalt. Im Bereich der Stirnflächen der Polplatten wird ein magnetisches Streufeld erzeugt, welches sich von der ersten Polplatte ausgehend in den Detektionsbereich hinein erstreckt und wieder zur zweiten Polplatte zurückführt. Ist ein ferromagnetisches Werkstück in der Nähe beider Stirnflächen, dann schliessen sich die magnetischen Feldlinien im Bereich der Stirnflächen über das ferromagnetische Werkstück. Dadurch wird die Feldlinienverteilung des vom Magnetfelderzeuger generierten Magnetfelds in der ganzen Sensorvorrichtung bei Anwesenheit eines Werkstücks im Detektionsbereich im Vergleich zu dem gemessenen lokalen Magnetfeld ohne Anwesenheit eines Werkstücks stark verändert, was durch den Magnetfeldsensor im Wirkbereich des Magnetfelds erfasst werden kann.

Die Ausrichtung der Stirnflächen in einer Ebene hat besondere Vorteile für die Erfassung von ferromagnetischen Werkstücken, deren Aussenkontur in der Ebene auf der zur Sensorvorrichtung benachbarten Seite eine gerade Linie respektive Bezugsgerade aufweist, die parallel zur Bezugsebene verläuft. Insbesondere bei zylindrischen Werkstücken wie zum Beispiel Gitterdrähten entspricht diese Bezugsgerade einer Mantelstrecke. Durch die Ausrichtung der Stirnflächen in einer Ebene kann das ferromagnetische Werkstück mit seiner Bezugsgeraden sehr nahe an die Stirnflächen positioniert werden, wodurch bei Annäherung des Werkstücks eine sehr starke Magnetfeldänderung resultieren kann.

In einer besonderen Ausführungsform sind die Stirnflächen der ersten und der zweiten Polplatte mit ihren benachbarten Seiten vorzugsweise parallel zueinander ausgerichtet. Dadurch kann das Werkstück in einer Richtung, welche in der Bezugsebene liegt, parallel verschoben werden, ohne dass sich die erfasste elektrische Grösse des Magnetfeldsensors wesentlich ändert.

In einer besonderen Ausführungsform ist der Abstand zwischen der ersten und der zweiten Polplatte zueinander so gewählt sein, dass durch eine Annährung des Werkstücks in Richtung der Stirnfläche eine deutliche Magnetfeldänderung bewirkt wird.

In einer alternativen Ausführungsform der Erfindung sind die Stirnflächen nicht in einer gemeinsamen Ebene angeordnet. Beispielsweise können die beiden Stirnflächen rechtwinklig zueinander angeordnet sein und/oder die Stirnflächen die Form eines Teilzylinders haben. Ebenso können in einer anderen alternativen Bauform die erste und zweite Stirnfläche zylindrisch ausgebildet sein und mit ihren benachbarten Seiten nicht parallel, sondern konzentrisch zueinander angeordnet sein. Diese alternativen Ausführungsformen können sich bei bestimmten Werkstückgeometrien als vorteilhaft erweisen. Zudem ermöglichen sie eine Positionsüberwachung in mehrere Richtungen, beispielsweise in einer Schweissstation. Dies ist vor allem nützlich, wenn nicht nur die Längsverschiebung des Werkstücks in Bezug auf eine Schweissstation bzw. der Abstand zu derselben, sondern auch eine tangentiale Verschiebung in Bezug auf die Höhe und/oder in Querrichtung zur einer Schweissstation überwacht werden soll.

In einer besonderen Ausführungsform sind die beiden Stirnflächen einer ersten und zweiten Polplatte unmittelbar zum Detektionsbereich benachbart. In diesem Fall ist zwischen dem Stirnbereich der Polplatten keine zusätzliche Trennschicht und kein Gehäuse bzw. kein amagnetisches Gehäuse angeordnet.

In einer weiteren besonderen Ausführungsform definieren die Polplatten einen Zwischenraum. Ein erster Bereich des Zwischenraums, der bevorzugt benachbart zum Detektionsbereich ist, umschliesst den Magnetfelderzeuger mindestens teilweise, in bevorzugter Weise jedoch umschliesst er ihn ganz. Vorzugsweise umschliesst ein zweiter, zum ersten Bereich benachbarter, aber vom Detektionsbereich abgewandter Bereich des Zwischenraums, den Magnetfeldsensor mindestens teilweise, vorzugsweise umschliesst er ihn ganz.

In einer besonderen Ausführungsform definiert der Zwischenraum zwischen den Polplatten ein Volumen.

In Bezug auf diese Erfindung wird die dem Detektionsbereich zugewandte Seite als Vorderseite, die dem Detektionsbereich abgewandte Seite als Hinter- bzw. Rückseite der Sensorvorrichtung bezeichnet.

In einer besonderen Ausführungsform ist mindestens ein Teil des Magnetfelderzeugers im ersten Bereich des Zwischenraums respektive im vorderen Bereich der Sensorvorrichtung angeordnet, bevorzugt im Bereich, welcher an den Detektionsbereich angrenzt, so dass ein grosser Anteil der vom Magnetfelderreger generierten magnetischen Feldlinien im Detektionsbereich austritt. Dadurch kann die Flussdichte im Detektionsbereich erhöht werden, was sich wiederum positiv auf die Messempfindlichkeit und Robustheit der Sensorvorrichtung auswirkt.

In der alternativen besonderen Ausführungsform, wo der Magnetfeldsensors in einem zweiten Bereich des Zwischenraums angeordnet ist und somit in der Sensorvorrichtung hinter dem Magnetfelderzeuger angeordnet ist, hat zum Vorteil, dass der Magnetfeldsensor weiter vom Bearbeitungsprozess entfernt, und somit weniger den Störeinflüssen durch den Schweissprozess ausgesetzt ist.

Insbesondere bei einer Anordnung, bei welcher der Zwischenraum in einem zweiten Bereich den Magnetfeldsensor ganz umgibt, ist dieser zu einem grossen Teil durch die Polplatten vor externen Magnetfeldern geschützt, so dass er im Wesentlichen nur Magnetfeldänderungen erfasst, welche sich aus der Anwesenheit eines ferromagnetischen Werkstücks im Detektionsbereich ergibt.

In einer weiteren besonderen Ausführungsform kann der Magnetfeldsensor in der Sensorvorrichtung auch vor dem Magnetfeldsensor angebracht sein, so dass er die lokale Magnetfeldänderung in der Nähe des Detektionsbereichs erfasst.

In einer weiteren besonderen Ausführungsform der Erfindung ist der Magnetfelderzeuger so ausgelegt, dass das von ihm erzeugte und über die Anordnung der Polplatten im Detektionsbereich konzentrierte Magnetfeld ferromagnetische Werkstücke, insbesondere Gitterdrähte, durch magnetische Anziehungskraft in eine Sollposition zu positionieren vermag. In einer weiteren Ausführungsform ist die Sollposition ist durch eine. Anschlagfläche definiert.

In einer besonderen Ausführungsform ist der Magnetfelderzeuger so angeordnet, dass ein Magnetkreis aus Magnetfelderzeuger und Polplatten besteht, welcher so dimensioniert ist, dass das Werkstück ab einem bestimmten Abstand auf einen Anschlag gezogen wird, der gleichzeitig die Sollposition für eine Bearbeitung bildet. Dadurch kann das Werkstück für die Bearbeitung sehr genau positioniert werden und eine weitere Positioniervorrichtung entfallen.

In einer alternativen oder ergänzten besonderen Ausgestaltungsform kann ein zusätzlicher separater Magnetanschlag das Werkstück auf einen Anschlag ziehen und positionieren. Alternativ oder ergänzend kann eine zusätzliche Positioniervorrichtung, wie beispielsweise ein pneumatischer, hydraulischer oder elektromechanischer Aktor für die Positionierung der Werkstücke vorgesehen sein.

In einer weiteren besonderen Ausführungsform wird die Anschlagfläche durch die Stirnflächen der Polplatten definiert, so dass das ferromagnetische Werkstück in der Sollposition im Wesentlichen einen magnetischen Kurzschluss mit den beiden Polplatten herstellt.

Durch den direkten Kontakt des ferromagnetischen Werkstücks mit den Stirnflächen der Polplatten können sich die Feldlinien direkt über das ferromagnetische Werkstück schliessen, da dieses im Vergleich zur Luft einen sehr kleinen magnetischen Widerstand hat. Im Moment, in welchem das ferromagnetische Werkstück die Anschlagfläche erreicht, resultiert daraus eine Magnetfeldänderung, welche an geeigneten Stellen im Wirkfeld des Magnetfelderzeugers durch den Magnetfeldsensor erfasst werden kann.

Ferromagnetische Werkstücke sind vielfach oberflächenveredelt, beispielsweise durch Brünieren, Galvanisieren oder Feuerverzinken, so dass sie eine nicht ferromagnetische Schutzschicht aufweisen. Die Werkstücke können auch mit einer nicht ferromagnetischen Oxidationsschicht oder Fett- bzw. Ölschicht überzogen sein. Gleiches gilt für die Stirnflächen der Polplatten, die gleichsam wie die Werkstücke eine amagnetische Schicht an der Oberfläche aufweisen können. Mit der Formulierung "im Wesentlichen ein magnetischer Kurzschluss" wird in dieser Erfindung ein direkter Kontakt zwischen dem ferromagnetischen Werkstück mit mindestens zwei entgegengesetzt polarisierten Polplatten bezeichnet, sofern der magnetische Widerstand zwischen den entgegengesetzt polarisierten Polplatten durch den direkten Kontakt mit dem Werkstück deutlich kleiner ist als der magnetische Widerstand zwischen den polarisierten Polplatten ohne die Anwesenheit des ferromagnetischen Werkstücks im Detektionsbereich.

In einer weiteren besonderen Ausführungsform der Erfindung vermag die Sensorvorrichtung über das in die elektrische Grösse umgewandelte lokale Magnetfeld, den Abstand des ferromagnetischen Werkstücks zur Anschlagfläche zu erfassen, insbesondere, ob sich das Werkstück in der Sollposition befindet. Durch die analoge elektrische Messgrösse kann nicht nur digital erfasst werden, ob ein Werkstück im Detektionsbereich erfasst wurde, sondern es kann auch sein Abstand zur Anschlagfläche ermittelt werden, da zwischen der elektrischen Grösse und dem Abstand ein Zusammenhang besteht. Es kann zudem frühzeitig erkannt werden, wenn sich das Werkstück der Sollposition nähert. Durch die analoge elektrische Grösse kann die Sollposition zuverlässiger erkannt werden, da beispielsweise Schwellwerte an einen Werkstücktyp aber auch an Signaltrends angepasst werden können.

In einer weiteren besonderen Ausführungsform umfasst die Sensorvorrichtung eine auswechselbare amagnetische Verschleissplatte, welche im ersten Bereich zwischen dem Magnetfelderzeuger und dem Detektionsbereich angeordnet ist, um den Magnetfelderzeuger vor Beschädigungen zu schützen.

Die Verschleissplatte schützt den Magnetfelderzeuger vor Verschmutzungen wie Ablagerungen von Schweissspritzern und sonstigen Beschädigungen, wodurch die Erfindung noch robuster und zuverlässiger wird.

Durch die Verwendung einer auswechselbaren Verschleissplatte wird die Lebensdauer der Sensorvorrichtung erhöht und die Wartung vereinfacht.

Alternativ oder ergänzend wäre es möglich, eine Schutzfläche vor dem Magnetfelderzeuger in das amagnetische Gehäuse zu integrieren.

In einer besonderen erfindungsgemässen Ausführungsform sind die Polplatten im Wesentlichen ebenflächig ausgebildet und parallel zueinander angeordnet, wobei ein durch den Magnetfelderzeuger definierter magnetischer Dipol senkrecht zu den Polplatten orientiert ist. Diese Ausführungsform ist kostengünstig herzustellen, mechanisch robust und ermöglicht eine schmale und kompakte Bauweise der Sensorvorrichtung. Durch die Plattenform der ferromagnetischen Polplatten kann der Magnetfeldsensor sehr einfach vor elektromagnetischen Störungen geschützt werden.

Besonders platzsparend erweist sich diese Bauform, wenn mehrere Sensorvorrichtungen in Richtung der Dipolachse parallel zueinander angeordnet werden sollen, beispielsweise um einen Gitterdraht in Längsrichtung an mehreren Stellen zu überwachen.

In einer weiteren besonderen Ausführungsform ist der Magnetfelderzeuger entlang einer Längsachse ausgebildet und vorzugsweise quaderförmig, wobei die Längsachse senkrecht sowohl zur Dipolachse des Magnetfelderzeugers, als auch zur Anschlagfläche verläuft.

Alternativ könnte der Magnetfelderzeuger beispielsweise eine zylindrische Form oder die Form eines Quaders mit einer quadratischen Grundfläche besitzen.

In einer weiteren besonderen Ausführungsform ist der Magnetfelderzeuger ein Permanentmagnet, vorzugsweise ein Permanentmagnet aus Seltener Erde, und in einer noch bevorzugteren Weise aus Neodym-Eisen-Bor. Die Verwendung eines Permanentmagnets hat den Vorteil, dass keine zusätzliche Energiezuführung zum Erzeugen des Magnetfelds notwendig ist. Bei Verwendung von Magneten aus Seltener Erde wird aufgrund ihrer hohen Remanenzflussdichte eine sehr kompakte Bauform ermöglicht. Ganz besonders geeignet sind Permanentmagnete aus Neodym-Bor, welche eine besonders hohe magnetische Leistungsfähigkeit aufweisen. In Anwendungen, bei welchen hohe Betriebstemperaturen herrschen, sind jedoch auch Permanentmagneten aus Somarium-Cobalt vorteilhaft einzusetzen, da sie eine hervorragende Temperatur- und Korrosionsstabilität besitzen.

In einer alternativen Ausführungsform wird ein Elektromagnet als Magnetfelderzeuger verwendet. Die Verwendung von Elektromagneten als Magnetfelderzeuger ermöglicht es, die Feldstärke nach Bedarf über die Steuerung des Stroms durch den Magnetfelderzeuger anzupassen. Ebenso kann durch Abschalten des Magnetfelderzeugers bzw. Reduktion des Stroms durch den Magnetfelderzeuger auch ein positioniertes Teil freigegeben werden, so dass kleinere Kräfte für den Weiter- respektive den Abtransport des ferromagnetischen Werkstücks nach der Bearbeitung nötig sind. Dabei entfallen auch die relativ hohen Kosten für die Permanentmagnete. Gleichzeitig ist es auch möglich, den Strom zu modulieren und die Modulation des Messsignals bei der Auswertung zu berücksichtigen, um später das Nutzsignal von Störsignalen zu isolieren.

Eine weitere besondere Ausführungsform sieht der Verwendung eines Hallsensors als Magnetfeldsensor vor.

Der Hall-Sensor eignet sich besonders für die erfindungsgemässe Sensorvorrichtung, da er in einem grossen Temperaturbereich arbeitet, typischerweise einen grossen Messbereich besitzt und eine zum Magnetfeld proportionale Ausgangsspannung liefert und somit leicht in einen Auswertekreis integriert werden kann.

Alternativ könnten beispielsweise auch magnetoresistive Sensoren wie zum Beispiel ferromagnetische Dünnfilmsensoren eingesetzt werden.

Sofern sie sich nicht gegenseitig ausschliessen, kann eine erfindungsgemässe Sensorvorrichtung aus einer beliebigen Kombination der oben genannten Ausführungsformen bestehen.

Ein weiterer Aspekt der Erfindung betrifft ein Sensorsystem, welches eine Sensorvorrichtung nach mindesten einer der vorangehend beschrieben Ausführungsformen sowie eine Auswerteelektronik umfasst, wobei die Auswerteelektronik mindestens einen analogen Messsignaleingang für die elektrische Grösse des Magnetfeldsensors und mindestens einen Ausgang besitzt, welcher so ausgestaltet ist, dass er anzeigen kann, ob ein ferromagnetisches Werkstück in einer Sollposition detektiert wurde. Der Ausgang ist vorzugsweise ein Digitalausgang.

Durch das Sensorsystem werden alle Vorteile der erwähnten Sensorvorrichtung übernommen. Es erlaubt die robuste und zuverlässige Erfassung von Werkstücken in einer Schweissanlage. Zusätzlich erlaubt es eine einfache Integration der Sensorvorrichtung in eine Maschinensteuerung.

In einer besonders bevorzugten Ausführungsform umfasst das Sensorsystem mindestens einen Signalfilter zur Filterung des analogen Messsignals. Durch den Signalfilter können ungewollte Störeinflüsse eliminiert werden, wodurch das Sensorsystem robuster wird.

Insbesondere kann das gefilterte Messsignal auch bei der Ermittlung eines Kompensationssignals verwendet werden.

In einer weiteren bevorzugten Ausführungsform ist das Sensorsystem in der Lage, Umgebungseinflüsse durch eine kontinuierliche Korrektur des Messsignals zu kompensieren. Dabei besitzt es vorzugsweise mindestens einen Digitaleingang zur Steuerung der Korrektur des Messsignals.

Durch die kontinuierliche Korrektur werden Signaldrifts, welche aus Verschmutzungen und Umgebungseinflüssen resultieren, fortlaufend kompensiert. Vor allem können Einflüsse von ferromagnetischen Schweissspritzern auf den Messwert durch die kontinuierliche Signalkorrektur weitgehend kompensiert werden. Sogar Verschmutzungen, welche unmittelbar vor der Erfassung eines Werkstücks in seiner Sollposition auftreten, können kompensiert werden. Insbesondere ist kein diskretes und gezieltes Abfragen des Messwerts vor der Positionierung zur Ermittlung eines Kompensationswerts notwendig, so dass keine Zeit für eine Abfrage verloren geht, was sich negativ auf die immer kürzer werdenden Zykluszeiten zwischen den einzelnen Schweisszyklen auswirken könnte.

Durch den Digitaleingang kann das fortlaufende Ermitteln des Kompensationswerts gezielt gesteuert und beispielsweise während eines Schweissvorgangs, bei welchem ein gestörtes Messsignal den Kompensationswert verfälschen könnte, angehalten werden. Ebenso kann die kontinuierliche Ermittlung des Kompensationswertes auch gezielt ausgeschaltet werden, beispielsweise wenn ein Schweissvorgang läuft.

In einer weiteren besonderen Ausführungsform ist das Sensorsystem mit einem Daten- und Programmspeicher ausgestattet, in welchem u.a. Schwellwerte für die Werkstückerfassung sowie Auswerteprogramme, Auswertealgorithmen, Filterparameter und Filterstrukturen abgelegt werden können.

In einer weiteren besonderen Ausführungsform besitzt das Sensorsystem einen Analogausgang, welcher in der Lage ist, eine physikalische Grösse auszugeben, die in einem Zusammenhang mit der Beschaffenheit des Werkstücks steht, insbesondere einem Durchmesser, wenn es sich beim Werkstück um einen Gitterdraht handelt.

Der ermittelte Wert kann beispielsweise von einer übergeordneten Steuerung verarbeitet und ausgewertet werden. Falls beispielsweise zu dicke oder zu dünne Gitterdrähte zugeführt wurden, kann die Steuerung die Produktion abbrechen und Ausschuss vermeiden.

Alternativ kann ein externer Sensor die Werkstückgrösse erfassen, bzw. die Drahtdicke bei Gitterdrähten.

Ein weiterer Aspekt der vorliegenden Erfindung ist ein Verfahren zur Sollpositionsüberwachung von ferromagnetischen Werkstücken in einem Detektionsbereich in einer ferromagnetischen Schweissanlage. Das Verfahren umfasst die Schritte:
a) Messung des lokalen Magnetfelds im Wirkbereich des Magnetfelds der Sensorvorrichtung durch einen Magnetfeldsensor und Ausgabe eines entsprechenden aktuellen Messwertes;
b) Filterung des aktuellen Messwerts durch einen Signalfilter zur Ermittlung eines gefilterten Messwertes;
c) Verrechnen des aktuellen Messwerts mit dem gefilterten Messwert zur Ermittlung eines kompensierten Messwerts, um Drifteinflüsse durch Umgebungsänderungen zu kompensieren, insbesondere Umgebungsveränderungen durch ferromagnetische Verschmutzungen in Folge des Schweissprozesses;
d) Vergleichen des korrigierten Messwerts mit mindestens einer Überwachungsschwelle
e) und je nach Über- oder Unterschreiten der Überwachungsschwelle Ausgeben eines Vergleichsergebnisses, welches der Anwesenheit des ferromagnetischen Werkstücks in der Sollposition entspricht.

Dieses Verfahren eignet sich insbesondere bei der Verwendung einer erfindungsgemässen Sensorvorrichtung oder eines erfindungsgemässen Sensorsystems.

In einer besonderen Ausführungsform ist der Magnetfeldsensor ein Hallsensor.

Durch dieses Verfahren können langsame Änderungen des Messsignals, welche auf Störeinflüsse in der Schweissanlage, auf Änderungen der Messumgebung oder auch auf sonstige äussere Einflüsse zurückzuführen sind, auf robuste und einfache Weise kompensiert werden.

In einer bevorzugten erfindungsgemässen Ausgestaltungsform ist die Filterung eine Tiefpassfilterung und das Verrechnen umfasst eine Differenzbildung zwischen dem aktuellen Messwert und dem gefilterten Messwert.

Die Tiefpassfilterung mit einer nachfolgenden Differenzbildung zwischen dem aktuellen und dem gefilterten Messwert entspricht einer Hochpassfilterung des aktuellen Messwerts. Durch Tiefpassfilterung und die anschliessende Differenzbildung oder durch die Hochpassfilterung können Signaldrifts auf einfache und robuste Weise eliminiert werden. Die Filterparameter können sehr einfach parametriert werden.

Es gibt auch weitere geeignete Filtermethoden wie zum Beispiel eine gleitende Mittelwertbildung. Ebenso können auch Filtermethoden eingesetzt werden, welche eine vorausschauende Erfassung eines Werkstücks ermöglichen, beispielsweise kann durch ein Differentiator-Glied die Signaländerungsrate bei der Annäherung des ferromagnetischen Werkstücks mitberücksichtigt werden, was eine frühzeitige Erfassung des Werkstücks ermöglichen würde.

In einer weiteren vorteilhaften erfindungsgemässen Ausführungsform umfasst das Verfahren die Schritte der Analog- Digitalumwandlung des Messsignals vor der Filterung, wobei der Filter bei Anwesenheit des ferromagnetischen Werkstücks und/oder durch ein externes digitales Eingangssignal gesteuert wird. Insbesondere wird das Filter während des Schweissprozesses angehalten, um ein Wegdriften der Überwachungsschwelle zu vermeiden.

Eine numerische Realisierung des Filters ist nicht nur sehr genau, sondern ermöglicht eine flexible Anpassung der Filterparameter und/oder der Filterstruktur an die Umgebungsbedingungen und Integration in ein Auswerteprogramm Bei einem Werkstückwechsel können die Filterparameter einfach über ein in einem Programmspeicher gespeichertes Programm angepasst werden.

Alternativ oder ergänzend zu einem numerischen Filter kann auch ein analoger Filter vor der Analog-/Digitalumwandlung verwendet werden. Dieser erlaubt, auch hochfrequente Störsignale zuverlässig zu filtern, jedoch ist der analoge Filter weniger flexibel und kann durch seine analogen Komponenten zu Signaldrifts führen. Insbesondere unterschiedliche Offsets zwischen dem aktuellen Messwert und dem geglätteten Messwert sowie Lineariäts- und Amplitudenfehler wirken sich direkt negativ auf die Genauigkeit des kompensierten Messwerts aus.

Schweissströme können die aktuellen Messwerte so stark stören, dass die Bestimmung des kompensierten Messwertes fehlerhaft wird. Ebenso würde das elektrische Messsignal des Magnetfeldsensors bei einem im Detektionsbereich erfassten Werkstück die Ermittlung des Kompensationswerts verfälschen. Daher ist es vorteilhaft, den Filter anzuhalten, wenn das Schweissen aktiv bzw. wenn ein Werkstück im Detektionsbereich der Sensorvorrichtung ist.

Die Analog-/Digitalumwandlung und die Filterung kann auch direkt im Magnetfeldsensor selber oder auf einer Sensorplatine erfolgen. Dies hat den Vorteil, dass durch die kurzen Signalwege die Signal-Störungen minimiert werden.

Besonders bevorzugt wird in dem erfindungsgemässen Verfahren der kompensierte Messwert verwendet, um den Drahtdurchmesser zu ermitteln.

Die Erfindung betrifft auch eine Schweissanlage, insbesondere eine Gitterschweissanlage, welche mit mindestens einer erfindungsgemässen Sensorvorrichtung oder einem Sensorsystem nach einer der zuvor in der Beschreibung aufgeführten Ausführungsformen ausgerüstet ist. Die Schweissanlage übernimmt alle Vorteile der oben beschriebenen Sensorvorrichtung oder des oben beschriebenen Sensorsystems.

Die Erfindung betrifft auch die Verwendung einer erfindungsgemässen Sensorvorrichtung oder eines erfindungsgemässen Sensorsystems in einer Schweissanlage, insbesondere in einer Gitterdrahtschweissanlage. Die Schweissanlage erbt dadurch alle Vorteile, welche sich aus der oben beschriebenen Sensorvorrichtung oder des oben beschriebenen Sensorsystems ergeben.

Im Folgenden wird die Erfindung anhand von Figuren und konkreter Ausführungsbeispiele näher erläutert, ohne allerdings auf diese eingeschränkt zu sein.

Aus der Detailbeschreibung und der Gesamtheit der Patentansprüche können sich zudem weitere vorteilhafte Ausführungsformen und Merkmalskombinationen der Erfindung ergeben.

### Kurze Beschreibung der Zeichnungen

Die zur Erläuterung des Ausführungsbeispiels verwendeten Zeichnungen zeigen:
- Fig. 1a und 1b:: Prinzipskizze einer erfindungsgemässen Sensorvorrichtung; Fig. 1a zeigt Frontansicht und Fig. 1b Schnitt durch eine Schnittebene I - I.
- Fig. 2a:: Perspektivische und schematische Ansicht einer erfindungsgemässen Sensorvorrichtung in zusammengebauten Zustand;
- Fig. 2b:: Perspektivische und schematische Ansicht der erfindungsgemässen Sensorvorrichtung gemäss Fig. 2a, jedoch mit demontierter ferromagnetischer Polplatte;
- Fig. 3a:: Perspektivische und schematische Ansicht einer weiteren erfindungsgemässen Sensorvorrichtung;
- Fig. 3b:: Perspektivische und schematische Teilansicht der Sensorvorrichtung aus Fig. 3a, jedoch ohne ferromagnetische Polplatte;
- Fig. 4:: Schematische Perspektivansicht eines Gitterdrahtscheissmoduls mit zwei Einzelschweissmodulen einer erfindungsgemässen Gitterdrahtschweissanlage;
- Fig. 5:: Schematische Darstellung der Auswerteeinheit;
- Fig. 6:: Flussdiagramm der Auswertung;

Grundsätzlich sind in den Figuren gleiche Teile mit gleichen Bezugszeichen versehen.

### Wege zur Ausführung der Erfindung

In den folgenden Zeichnungen sind ähnliche oder gleiche Elemente von verschiedenen Ausführungsformen durch ähnliche Bezugszeichen gekennzeichnet, welche sich durch ihre Hunderterziffer unterscheiden, sofern sie in verschiedenen Zeichnungen dargestellt sind.

In den folgenden Beispielen ist eine Vorrichtung gezeigt, die insbesondere zur Positionsüberwachung von ferromagnetischen Gitterdrähten 103 in einer Schweissanlage vor und/oder während des Schweissens, sowie zu deren Positionierung durch magnetische Anziehung geeignet ist.

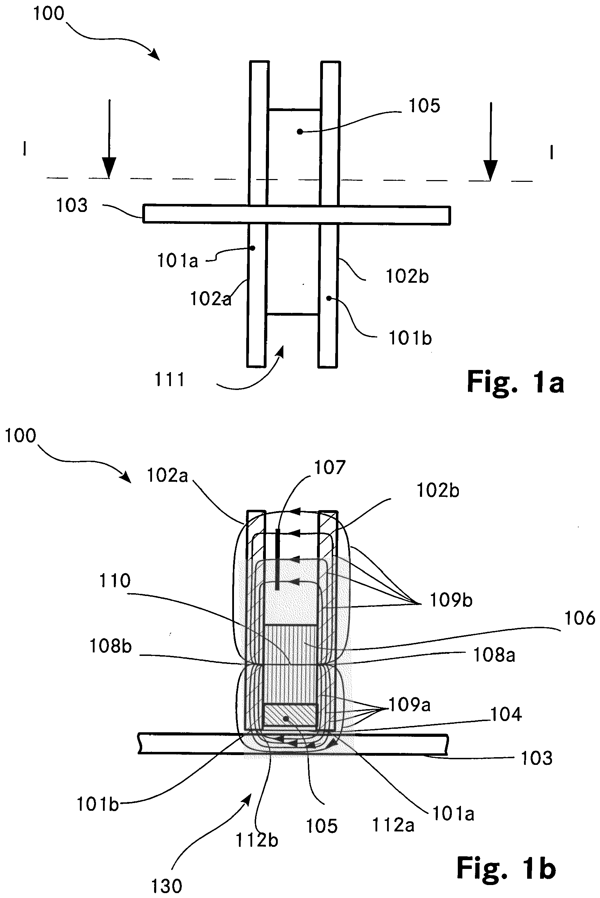

Eine Prinzipskizze der erfindungsgemässen Sensorvorrichtung 100 ist in Fig. 1a und Fig. 1b dargestellt. Fig. 1a zeigt dabei eine Frontansicht der Sensorvorrichtung 100 und Fig. 1b eine Schnittansicht entlang einer Schnittebene I-I durch dieselbe Sensorvorrichtung 100. Die Sensorvorrichtung 100 ist in den beiden Ansichten jeweils mit einem Gitterdraht 103 dargestellt, dessen Position überwacht werden soll. Die Sensorvorrichtung 100 umfasst eine erste Polplatte 102a und eine zweite Polplatte 102b, welche parallel zueinander angeordnet sind und die zwischen sich einen quaderförmigen Zwischenraum 111 definieren. Die beiden Polplatten 102a und 102b besitzen jeweils eine Stirnfläche 101a und 101b, die in einer Ebene liegen und eine Anschlagfläche 104 für den Gitterdraht 103 bilden. Gleichzeitig definieren die Stirnflächen 101a und 101b respektive die Anschlagfläche 104 auch die durch die Sensorvorrichtung 100 zu überwachende Sollposition.

In einem ersten Teilbereich des Zwischenraums 111, der an die Stirnflächen 101a und 101b angrenzt, und welcher im Weiteren als vorderer Teil bezeichnet wird, befindet sich hinter einer quaderförmigen amagnetischen Verschleissplatte 105 ein ebenfalls quaderförmiger Permanentmagnet 106 aus Neodym-Bor. Die Verschleissplatte 105 schützt den Permanentmagneten 106 vor mechanischen Beschädigungen und beispielsweise auch vor Schweissspritzern, welche von einer unmittelbar angrenzenden oder auch von einer direkt benachbarten oder weiter entfernt benachbarten Schweissstation stammen können. Die Verschleissplatte 105 ist in Bezug auf die Anschlagfläche 104, d.h. gegenüber den Stirnflächen 101a und 101b der beiden Polplatten 102a und 102b in Bezug auf den Detektionsbereich 130 leicht zurückversetzt.

Im einem hinteren Bereich des Zwischenraums 111 befindet sich ein Hall-Sensor 107, dessen Detektionsfläche parallel zu den beiden ferromagnetischen Polplatten 102a, 102b ausgerichtet ist und welcher ein elektrisches Signal erzeugt, welches proportional zum magnetischen Fluss durch die Detektionsfläche, und damit zum lokalen magnetischen Feld am Ort des Hallsensors 107 ist.

Der Permanentmagnet 106 ist in einer Richtung senkrecht zu den beiden Polplatten polarisiert, wobei der magnetische Nordpol 108a des Permanentmagneten der ersten Polplatte 102a und der magnetische Südpol 108b des Permanentmagneten der zweiten ferromagnetischen Polplatte 102b gegenüberliegt. Die beiden magnetischen Pole 108a und 108b definieren einen magnetischen Dipol, welcher in Fig. 1b durch eine Dipolachse 110 dargestellt ist. Die vom magnetischen Nordpol 108a zum magnetischen Südpol 108b verlaufenden Feldlinien teilen sich im Wesentlichen in zwei Feldliniengruppen auf, wobei die Verteilung der Feldlinien baulich bedingt ist und sich bei Anwesenheit eines ferromagnetischen Materials im Detektionsbereich 130 verändert, beispielsweise bei Anwesenheit des Gitterdrahts 103. Die im Folgenden beschriebenen Feldlinienverläufe sind der Übersichtlichkeit halber nur in der Schnittzeichnung 1b dargestellt. Die Feldlinien einer ersten Feldliniengruppe 109a durchqueren ausgehend vom magnetischen Nordpol 108a die erste ferromagnetische Polplatte 101a, bevor sie den Detektionsbereich 130 durchdringen, in welchem die Position des Gitterdrahts 103 überwacht werden soll, und über die zweite ferromagnetische Polplatte 102b zum magnetischen Südpol 108b zurückführen. Die Feldlinien der zweiten Feldliniengruppe 109b durchqueren ebenso die erste Polplatte 102a, verlassen diese aber im hinteren Bereich, d.h. der vom Detektionsbereich 130 abgewandten Seite der Sensorvorrichtung 100, und durchqueren den zweiten Teilbereich des von den Polplatten 102a, 102b gebildeten Zwischenraums 111, im Folgenden hinterer Bereich genannt, welcher auf der vom Detektionsbereich 130 abgewandten Seite des Zwischenraums liegt. Die magnetischen Feldlinien der zweiten Feldliniengruppe 109b führen anschliessend über die zweite Polplatte 101b zum magnetischen Südpol 108b zurück.

Befindet sich nun ein ferromagnetisches Werkstück, in diesem Ausführungsbeispiel ein Gitterdraht 103, im Detektionsbereich 130, wie in den beiden Figuren Fig. 1a und 1b dargestellt, dann konzentrieren sich die Feldlinien der ersten Feldliniengruppe 109a im ferromagnetischen Gitterdraht 103, wohingegen die Feldliniendichte und damit das magnetische Feld der zweiten Feldliniengruppe 109b im Vergleich zu einem Zustand, in welchem sich kein ferromagnetisches Werkstück 103 im Detektionsbereich 130 befindet, abgeschwächt werden. Diese Änderung bewirkt, dass der mit der Hallsensor 107 ein elektrisches Signal liefert, welches ebenfalls abgeschwächt wird, wobei die Abschwächung proportional zur Abnahme des vom Hall-Sensor erfassten magnetischen Flusses ist. Die Änderung kann dabei nicht nur im Betrag sondern auch in der Geschwindigkeit respektive über die Änderungsrate ausgewertet werden.

Da Luft und das ferromagnetische Material des Gitterdrahts 103 eine unterschiedliche relative Permeabilität haben, und bei Annäherung des ferromagnetischen Gitterdraht 103 der magnetische Widerstand zwischen den beiden Polplatten 102a und 102b verringert wird, resultiert auch eine magnetischen Reluktanzkraft zwischen den ferromagnetischen Polplatten 102a, 102b und dem Gitterdraht 103, welche in Richtung der Stirnflächen 101a und 101b der beiden Polplatten 102a, 102b wirkt und somit den Gitterdraht 103 bis zum Anschlag gegen die durch Stirnflächen 101a, 101b definierte Anschlagfläche 104 der beiden Polplatten 102a, 102b zu ziehen vermag, insofern der Gitterdraht 103 nicht vorher auf ein Hindernis trifft, oder durch eine Gegenkraft abgebremst wird. Im Anschlag bewirkt der ferromagnetische Gitterdraht 103 durch seine hohe relative Permeabilität nahezu einen magnetischen Kurzschluss zwischen den ferromagnetischen Polplatten 102a und 102b. Je nach Oberflächenbeschaffenheit der Polplatten 102a, 102b und insbesondere des Gitterdrahts 103 bleibt jedoch ein gewisser Luftspalt (im magnetischen Sinne) bestehen. Beispielsweise kann der Gitterdraht oxidiert oder verzinkt sein, so dass trotz des direkten Kontaktes ein Luftspalt im magnetischen Sinne zwischen den Stirnseiten 101a, 101b der ferromagnetischen Polplatten 102a, 102b und dem ferromagnetischen Gitterdraht 103 bestehen bleibt.

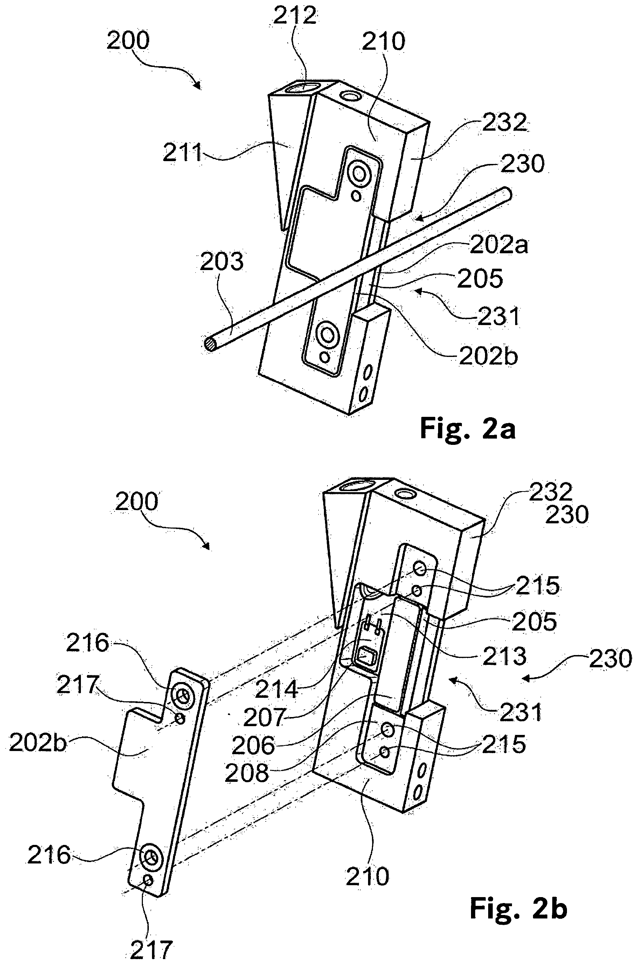

Fig. 2a und Fig. 2b zeigen eine weitere erfindungsgemässe Ausführungsform der Sensorvorrichtung 200. Fig. 2a zeigt eine erste perspektivische Ansicht der Sensorvorrichtung 200 im zusammengebauten Zustand zusammen mit einem Gitterdraht 203, während Fig. 2b eine zweite perspektivische Darstellung derselben Sensorvorrichtung 200 zeigt, bei welcher die zweite Polplatte 202b demontiert ist. Die Sensorvorrichtung 200 umfasst ein amagnetisches Gehäuse 210, welches vorzugsweise aus einem metallischen Werkstoff wie Aluminium oder einem rostfreien Edelstahl hergestellt ist, aber auch aus einem temperaturbeständigen Kunststoff sein kann. Das amagnetische Gehäuse hat eine quaderförmige Grundform. Eine der beiden langen Schmalseiten des amagnetischen Gehäuses 210 ist in Richtung des Detektionsbereich 230 orientiert und stellt die Stirnseite 232 der Sensorvorrichtung dar. In Richtung dieser Seite werden die zu detektierenden Gitterdrähte 203 bewegt, bevor sie geschweisst werden. An der zweiten Schmalseite respektive auf der Rückseite, ist ein Befestigungsstück 211 angebracht, das die Befestigung des amagnetischen Gehäuses an eine Schweissmaschine ermöglicht. Es dient ebenso der Führung der elektrischen Versorgungs- und Signalleitungen (nicht dargestellt), wozu es mit einem Kabelkanal 212 ausgestattet ist.

Auf den breiten Seiten besitzt das amagnetische Gehäuse 210 Aussparungen für die ferromagnetischen Polplatten 202a, 202b (in Fig. 2a ist nur die Aussparung 208 für die zweite ferromagnetische Polplatte 202b dargestellt). Ebenso sind Aussparungen für den Permanentmagneten 206 und die Sensorplatine 214 mit dem Hallsensor 207 vorgesehen.

Die beiden ferromagnetischen Polplatten 202a, 202b sind jeweils einteilig ausgeführt, wobei jede der Polplatten 202a, 202b jeweils eine vorwiegend rechtwinklige Form, respektive eine T-Form hat. Diese ergibt sich, wenn man eine etwas kürzere rechteckige Platte mit einer langen Schmalseite an die lange Schmalseite einer längeren rechteckigen Platte ansetzt. Wegen der Aussermittigkeit der durch die ferromagnetische Polplatte abzudeckenden Sensorplatine 214 in Bezug auf das amagnetische Gehäuses 210 ist die kürzere Platte leicht asymmetrisch zur längeren Platte angesetzt. Die beidseitigen Aussparungen für die ferromagnetischen Polplatten 202a, 202b und Durchgangslöcher 215 im amagnetischen Gehäuse ermöglichen die Befestigung der Polplatten 202a, 202b durch gegenseitiges Verschrauben, so dass die aussenliegenden Flächen der Polplatten 202a, 202b bündig mit dem amagnetischen Gehäuse 210 verlaufen.

Für die gegenseitige Verschraubung hat jede Polplatte zwei Durchgangslöcher 216 zur Aufnahme eine Senkkopfschraube, sowie zwei Gewindelöcher 217. Im hinteren Teil des Gehäuses, dient eine Aussparung für die Hallsensorplatine 213 als weitere Vertiefung in der Aussparung 208 der Aufnahme der Sensorleiterplatte 214 mit dem Hallsensor 207.

Ferner besitzt das amagnetische Gehäuse 210 auf der Stirnseite 232 im mittleren Bereich eine Öffnung 231, hinter der sich eine weitere quaderförmige Aussparung zur Aufnahme des quaderförmigen Permanentmagneten 206 aus Neodym-Bor, sowie der ebenfalls quaderförmigen amagnetischen Verschleissplatte 205 befindet. Die Öffnung 231 in der Stirnseite 232 ist etwas kürzer als die Länge des Permanentmagneten 206 und die Länge der in etwa gleichlangen Verschleissplatte 205. Im montierten Zustand schliessen zudem die beiden ferromagnetischen Polplatten 202a, 202b mit ihrem jeweils längeren Bereich sowohl den Permanentmagneten 206 als auch die Verschleissplatte 205 ein. Dadurch werden mittels der beiden ferromagnetischen Polplatten 202a, 202b sowohl der Permanentmagnet als auch amagnetische Verschleissplatte 205 im amagnetischen Gehäuse 210 fixiert. Mit ihrem kürzeren, respektive hinteren Bereich umschliessen die beiden ferromagnetischen Polplatten 202a, 202b beidseitig den Hallsensor 207 und die Sensorplatine 214. Dadurch werden einerseits elektromagnetische Störungen abgeschirmt, andererseits werden die magnetischen Feldlinien durch die Polplatten auch in den Bereich des Hallsensors 207 geführt, der mit seiner Fläche parallel zu den magnetischen Feldlinien ausgerichtet ist. Die auswechselbare Verschleissplatte 205 schützt den Permanentmagneten 206 vor mechanischer Beanspruchung, insbesondere vor Schweissspritzer.

Die Verschleissplatte 205 ist gegenüber den Stirnseiten der ferromagnetischen Polplatten 202a und 202b gegenüber dem Werkstück zurückversetzt, so dass die Stirnseiten der ferromagnetischen Polplatten 202a und 202b den mechanischen Anschlag für ein in Richtung der Sensor hinzubewegten Gitterdraht 203 bilden und der Gitterdraht im Anschlag nahezu einen magnetischen Kurzschluss zwischen den beiden ferromagnetischen Polplatten 202a, 202b herstellt, die wie die Polschenkel eines magnetischen Kreises wirken. Durch den magnetischen Kurzschluss resultiert eine starke Reluktanzänderung. Dadurch wird auch der magnetische Fluss, welcher durch den Hallsensor 207 erfasst wird, stark verändert. Diese magnetische Flussänderung, beispielsweise eine Verringerung des magnetischen Flusses, führt zu einer entsprechenden Änderung der elektrischen Ausgangsgrösse des Hall-Sensors 207.

Der Magnetkreis, welcher im Wesentlichen durch die geometrische Form und Anordnung der beiden ferromagnetischen Polplatten 202a, 202b und des Permanentmagneten sowie dessen Feldstärke bestimmt wird, ist so ausgestaltet, dass er einen Gitterdraht 203 in Richtung der Anschlagflächen zu ziehen und positionieren sowie auf dem Anschlag zu halten vermag. Aufgrund der länglichen Ausgestaltung der Polplatten 202a, 202b und des Permanentmagneten 207 entlang der Längsachse der Öffnung, respektive der Anschlagfläche, kann ein Gitterdraht auf verschiedenen Höhen detektiert und positioniert werden, nahezu im kompletten Bereich der Öffnung 231.

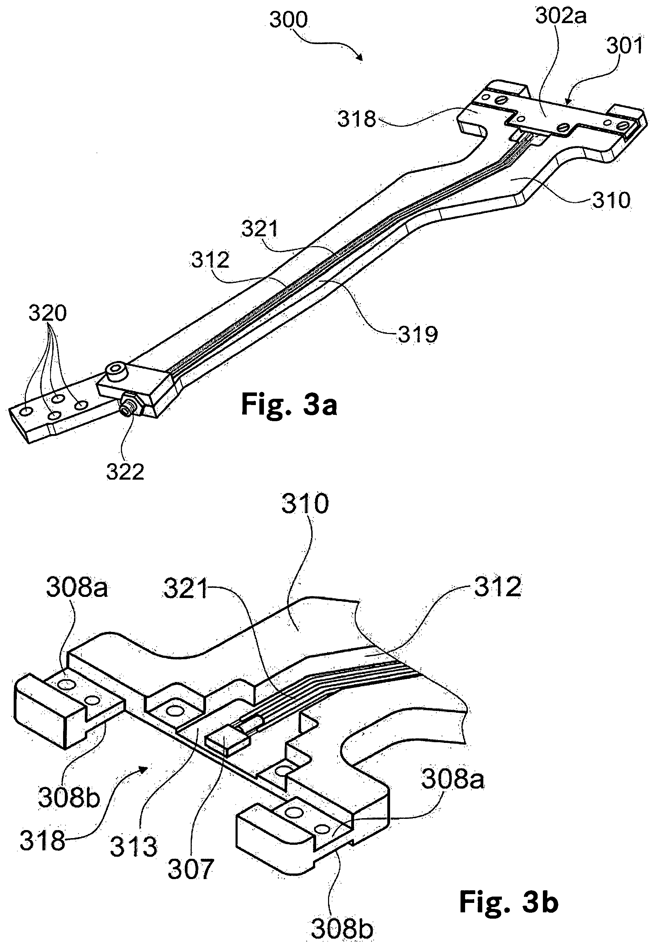

Die Figuren Fig. 3a und Fig. 3b zeigen eine alternative Ausführungsform der Erfindung. Im Gegensatz zum Ausführungsbeispiel gemäss den Figuren Fig. 2a und Fig. 2b ist das amagnetische Gehäuse 310 dieser Ausführungsform einstückig ausgebildet und die Haltevorrichtung 319 zur Befestigung der Sensorvorrichtung 300 an ein Maschinengehäuse in das amagnetische Gehäuse 310 integriert. Fig. 3a stellt eine perspektivische Gesamtansicht der zusammengebauten Sensorvorrichtung 300 dar. Fig. 3b zeigt dagegen das amagnetische Gehäuse ohne ferromagnetische Polplatten und ohne Permanentmagneten in einer Teilansicht. Das amagnetische Gehäuse 310 ist plattenförmig ausgebildet und weist auf der dem Detektionsbereich zugewandten Seite (in Fig. 3a rechts) einen quaderförmigen Sensorkopf 318 auf, sowie auf der entgegengesetzten Seite (in Fig. 3a links) einen langgezogenen Sensorkopfhalter 319 als Halterung, der an seinem Ende mit vier Durchgangsbohrungen zur Befestigung an ein Maschinengestell versehen ist. In den Sensorkopfhalter 319 ist ein Kabelkanal 312 für die Führung von elektrischen Strom- und Signalkabel 321 gefräst, welcher über eine Anschlussbuchse 322 mit einer Auswerteelektronik (nicht dargestellt) verbunden werden kann. In den Sensorkopf sind beidseitig Aussparungen 308a, 308b eingebracht, sowie eine Vertiefung zur Aufnahme eines Hallsensors 307, welcher hier direkt am amagnetischen Sensorgehäuse 310 befestigt ist.

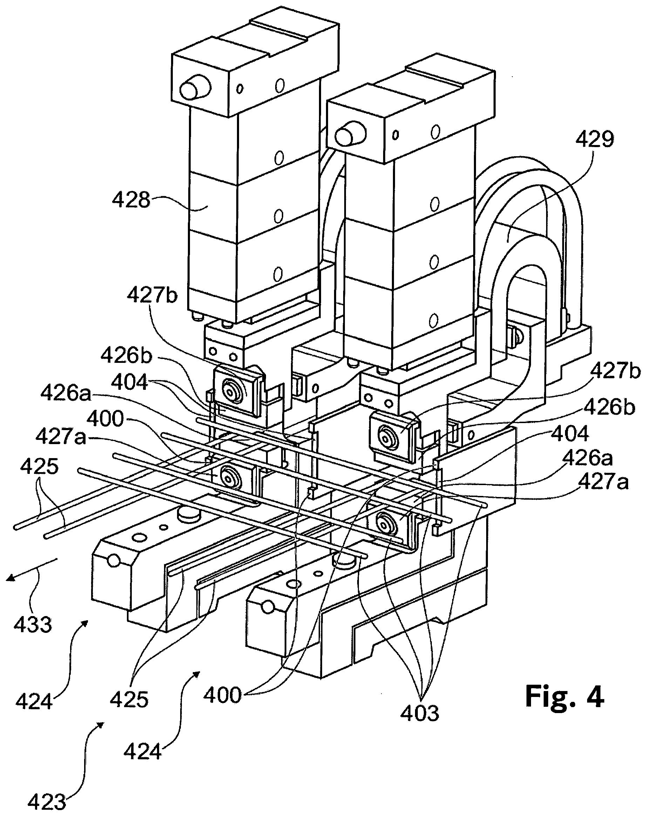

Fig. 4 zeigt eine perspektivische Ansicht eines Gitterdrahtschweissmoduls 423 einer erfindungsgemässen Gitterdrahtschweissanlage mit zwei identischen, parallel angeordneten Einzelschweisseinheiten 424. In einer Gitterschweissanlage werden durch elektrisches Widerstandsschweissen Querdrähte 403 und Längsdrähte 425 eines Gitters, beispielsweise eines Armierungs- oder Industriegitters, verschweisst. Für zwei Längsdrähte wird jeweils eine Einzelschweisseinheit 424 benötigt. Es können aber auch ein bis vier Längsdrähte pro Einzelschweisseinheit 424 verarbeitet werden.

Jedes Einzelschweissmodul umfasst eine untere Elektrode 426a und eine obere Elektrode 426b, welche jeweils von einem unteren Elektrodenhalter 427a respektive einem oberen Elektrodenhalter 427b gehalten werden. Zwischen den Einzelschweisseinheiten 424 ist jeweils eine erfindungsgemässe Sensorvorrichtung 400 angebracht, deren Anschlagflächen 404 zueinander in einer gemeinsamen Ebene quer zu den Längsdrähten 425 ausgerichtet sind, wobei die langen Seiten der Anschlagflächen 404 vertikal zu den Querdrähten 403 und den Längsdrähten 425 gerichtet verlaufen. Die Längsdrähte 425 werden den Einzelschweissmodulen 424 von der Rückseite her zwischen den beiden Elektroden 426a und 426b hindurch in Längsdrahtrichtung 433 zugeführt. Als Rückseite versteht sich dabei die den Anschlagflächen 404 respektive die dem Dektektionsbereich abgewandte Seite. Die Querdrähte 403 werden dagegen von der Seite in Querrichtung von schräg oberhalb der Sollposition für das Schweissen eingeworfen: in Bezug auf die Anschlagflächen 404 werden sie leicht von vorne und in Bezug auf die Längsdrähte 425 leicht von oberhalb eingeworfen. Durch die magnetische Anziehungskraft der Sensorvorrichtungen 400 (Reluktanzeffekt) wird ein sich in der Nähe der Anschlagflächen 404 befindlicher Querdraht 403 nach hinten in Richtung der Anschlagflächen 404 gezogen, während er sich gleichzeitig durch seine Gewichtskraft nach unten in Richtung der Längsdrähte bewegt und somit durch die beiden Überlagerten bewegten positioniert wird.

Durch die Sensorvorrichtungen 400 wird detektiert, ob der Querdraht 403 den Anschlag erreicht hat und entsprechend bei erfolgter Detektion der Schweissvorgang eingeleitet. Zur relativen Bewegung der Elektroden 426a und 426b zueinander, respektive für den Anpressvorgang, besitzt jedes Einzelschweisseinheit 424 einen pneumatischen Pressantrieb 428, der mit den Elektrodenhaltern 427a und 427b über die beiden Elektroden 426a und 426b den positionierten Querdraht 403 mit jeweils zwei Längsdrähten 425 für den Schweissvorgang zusammenpresst. Der Schweissstrom jeder Einheit wird über ein flexibles Stromband 429 zugeführt.

Beim Schweissvorgang werden die Gitterdrähte durch elektrischen Strom auf Schweisstemperatur erwärmt und Querdrähte 403 und Längsdrähte 425 durch gleichzeitiges Einwirken der Anpresskraft stoffschlüssig miteinander verbunden.

Es könnten einige der Sensorvorrichtungen 400 auch durch reine Positioniervorrichtungen ersetzt werden, respektive Vorrichtungen, welche den Sensorvorrichtungen entsprechen, jedoch keine Magnetfeldsensoren besitzen. Insbesondere bei einer Vielzahl von Einzelschweissmodulen müssen nicht alle Positionen überwacht werden.

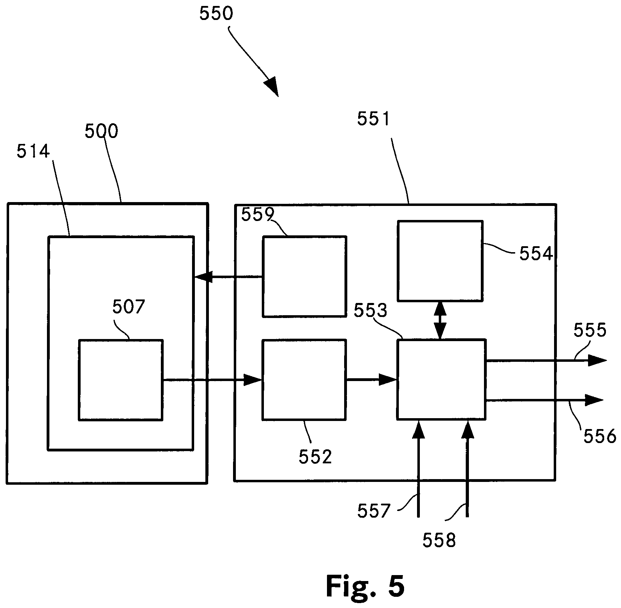

Fig. 5 zeigt eine schematische Darstellung eines erfindungsgemässen Sensorsystems 550. Das Sensorsystem 550 umfasst eine erfindungsgemässe Sensorvorrichtung 500, welche beispielsweise eine Sensorvorrichtung gemäss den Fig. 1a, 1b, 2a, 2b, 3a oder 3b sein kann, und eine Auswerteelektronik 551. Von der Sensorvorrichtung 500 ist nur eine Sensorplatine 514 mit einem Hall-Sensorelement 507 dargestellt. Die Auswertelektronik 551 umfasst einen Analog-/Digitalwandler 552 zu Wandlung der elektrischen Grösse am Ausgang des Hall-Sensors, beispielsweise eines 0 - 5 V Spannungswert oder eines 4 - 20 mA Stromwerts, in einen numerischen Wert, welcher dem vom Hall-Sensors 507 erfassten magnetischen Fluss entspricht. Es ist jedoch auch möglich, dass der Hall-Sensor 507, respektive die Hall-Sensorplatine, direkt einen numerischen Messwert an die Auswerteelektronik übergibt, wodurch der Analog-/Digitalwandler 552 eingespart werden könnte. Der digitalisierte Messwert wird an eine Prozessoreinheit 553 übergeben, die die Signalauswertung übernimmt. Die Prozesseinheit 553 ist mit einem Programm- und Datenspeicher 554 verbunden, welcher die unterschiedlichen Auswerteprogramme bereitstellt, aber auch die Speicherung von Programmparametern, wie beispielsweise Schwellwerte ermöglicht. Die Prozesseinheit 553 besitzt einen digitalen Detektionsausgang 555, welcher anzeigen kann, ob ein Werkstück eine Sollposition erreicht hat. Dieser digitale Detektionsausgang 555 liefert typischerweise ein 24Volt-Logik kompatibles Digitalsignal, welches von einer übergeordneten Steuerung, wie beispielsweise eine speicherprogrammierbaren Steuerung (SPS) weiterverarbeitet werden kann. Zudem besitzt die Prozessoreinheit einen Analogausgang 556, welcher ein Signal ausgeben kann, welches dem erfassten Durchmesser eines positionierten Gitterdrahtes entspricht. Die Auswerteeinheit ist in der Lage, Messabweichungen auf Grund von Verschmutzungen fortlaufend zu kompensieren. Die Auswerteeinheit besitzt einen Digitaleingang "Schweissen aktiv" 557, welcher anzeigt, ob gerade ein Schweissvorgang stattfindet. Dieser erlaubt es, einen Kompensationsalgorithmus zur Beseitigung von Störungen durch Umgebungsänderungen, wie zum Beispiel Schmutz in Form von Schweissspritzern, oder auch von temperaturbedingten Signaldrifts während eines Schweissvorgangs anzuhalten, da während desselben grosse Störungen die Bestimmung eines Kompensationswertes verfälschen könnte. Ausserdem besitzt die Auswerteeinheit eine Strom- und Spannungsversorgung 559, die einerseits die eigenen Baugruppen speist, aber auch Spannungsversorgung der Hall-Sensorplatine 514 übernimmt. Ein Digitaleingang für die Initialisierung (Digitaleingang "Initialisierung" 558) erlaubt es, dass System zu initialisieren, um zum Beispiel beim Start der Anlage, oder nach einem Serviceeinsatz, wie zum Beispiel einer Reinigung der Anlage, Kompensationswerte anzulernen bzw. auch zurückzusetzen.

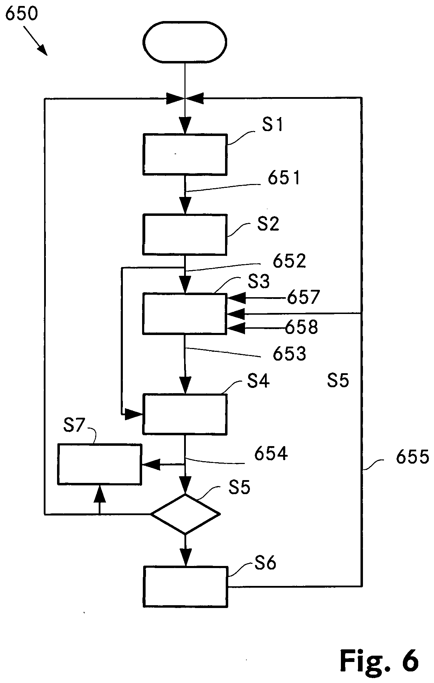

Fig. 6 zeigt ein Flussdiagramm 650 des erfindungsgemässen Verfahrens zur Sollpositionsüberwachung von ferromagnetischen Werkstücken, insbesondere von Gitterdrähten in einer Schweissmaschine, welche mit mindestens einer erfindungsgemässen Sensorvorrichtung ausgestattet ist. Das Verfahren umfasst die Schritte S1- S7, welche in einer Wiederholschleife S1-S7 ausgeführt werden. In Schritt S1 wandelt ein Hall-Sensor das lokale Magnetfeld an der Position des Hall-Sensors der Sensorvorrichtung in ein analoges elektrisches Spannungssignal 651 um, welches dann in einem nachfolgenden Schritt S2 durch einen Analog-Digital-Wandler-Modul abgetastet und in einen numerischen Messwert 652 umgewandelt wird. Dieser aktuelle numerische Messwert 652 entspricht dem vom Hall-Sensor erfassten lokalen Magnetfeld respektive dem vom Hall-Sensor erfassten magnetischen Fluss und durchläuft im anschliessenden Verarbeitungsschritt S3 einen numerischen Tiefpassfilter. Der Tiefpassfilter liefert einen geglätteten Wert 653 des magnetischen Flusses. Im nachfolgenden Schritt S4 wird durch Subtraktion des geglätteten Messwerts 653 vom aktuellen Messwert 652 ein kompensierter Messwert 654 des magnetischen Flusses bestimmt. Dieser kompensierte Messwert 654 widerspiegelt schnelle Änderungen des Magnetfelds, welche beispielsweise auftreten, wenn ein Werkstück, im Besonderen ein Gitterdraht, sich der Sollposition nähert, und dadurch das erfasste Magnetfeld am Ort des Hall-Sensors stark ansteigt oder abfällt. Insbesondere wenn bei der Positionierung des ferromagnetischen Werkstücks dieses mit den Stirnflächen der Polplatten in Kontakt kommt und somit ein magnetischer Kurzschluss erzeugt wird, ist mit einer abrupten Signaländerung zu rechnen. Langsame Signaländerungen respektive Signaldrifts auf Grund von Änderungen der Messumgebung werden so kontinuierlich kompensiert und verfälschen dementsprechend nicht das Messergebnis. Beispielsweise führen Verschmutzungen wie Schweissspritzer zu einer langsamen Drift der Feldlinienverteilung in der Sensorvorrichtung oder können sogar zu einem teilweisen Kurzschluss zwischen den beiden Polplatten der Sensorvorrichtung führen. Ebenso führen auch Temperaturschwankungen zu Signaldrifts in den elektronischen Bauteilen und damit zu einer Drift des aktuellen Messwerts 652, der jedoch zum Grossteil durch den geglätteten Wert 653 kompensiert werden kann. Der kompensierte Messwert 654 des magnetischen Flusses wird anschliessend durch Vergleichen mit einer oberen und/oder einer unteren Signalschwelle verglichen (Schritt S5). Falls der kompensierte Wert des magnetischen Flusses die untere Signalschwelle unterschreitet oder die obere Signalschwelle überschreitet, wird im nächsten Schritt S6 ausgegeben, dass das Werkstück positioniert ist, respektive der Ausgang "Werkstück positioniert" wird auf WAHR gesetzt. Somit kann beispielsweise einer übergeordneten Steuerung einer Schweissanlage signalisiert werden, dass der Pressantrieb einer Schweissanlage betätigt werden kann, um den zu schweissenden Querdraht an den Längsdraht zu pressen und dass der Schweissvorgang eingeleitet werden kann. Anschliessend wird wieder an den Anfang der Wiederholschleife S1-S7 zurückgekehrt und mit Schritt S1 fortgefahren. Wird die Signalschwelle im Vergleichsschritt S5 jedoch nicht überschritten, wird direkt zum Schritt S1 zurückgekehrt und vom Hall-Sensormodul der nächste Spannungswert ermittelt (Schritt S2) und die Wiederholschleife erneut durchlaufen.

Der in Schritt S4 ermittelte kompensierte Wert 654 und damit die quantitative Änderung der gemessenen Feldlinien lässt im positionierten Zustand einen direkten Rückschluss auf die Menge des in der Sensorvorrichtung befindlichen Materials mit einer gewissen Permeabilität zu. Wird folglich erkannt, dass das Werkstück die Sollposition erreicht hat, kann in einem zusätzlichen Schritt S7 aus der quantitativen Änderung, respektive aus dem kompensierten Messwert 654, ein Drahtdurchmesser ermittelt und an einem Analogausgang, nach einer DC/AC-Wandlung ausgegeben werden.

Die Umrechnung des kompensierten Messwerts in den Drahtdurchmesser kann dabei sowohl auf einer Umrechnungsformel als auch auf einer Look-Up-Tabelle basieren. Der ermittelte Drahtdurchmesser kann beispielsweise von einer übergeordneten Steuerung weiter verarbeitet werden. Ist die ermittelte Drahtdicke beispielsweise zu dünn oder zu dick, kann die Steuerung die Fertigung unterbrechen und folglich Materialausschuss vermeiden.

Die während des Schweissens benötigten hohen Ströme von einigen Kiloampere erzeugen ein störendes Magnetfeld, welche die aktuellen Messwerte 653 stark stören. Somit würde auch die Bestimmung des Kompensationswertes fehlerhaft. Gleiches gilt, wenn das Werkstück in Soll-Position ist bzw. das Werkstück detektiert wurde. In diesem Fall würde die Signaländerung aufgrund der Anwesenheit des Werkstückes den Kompensationswert verfälschen. Daher wird der Filter deaktiviert respektive die Kompensationswertbestimmung angehalten, wenn das Schweissen aktiv ist (digitaler Eingang "Schweissen aktiv" 657 ist WAHR) bzw. wenn das Werkstück in Sollposition ist respektive das Werkstück detektiert wurde. Das Deaktivieren oder Anhalten des Filters kann, sofern es sich um einen digitalen Filter handelt, beispielsweise durch Überspringen der Filter-Berechnungsroutine erfolgen, wodurch der Filterausgangswert und somit der Kompensationswert konstant gehalten werden. Sobald die beiden oben erwähnten Bedingungen nicht mehr erfüllt sind, wird der Filter wieder aktiv geschaltet und der aktuelle Wert des magnetischen Flusses wieder für die Bestimmung des gefilterten Wertes verwendet. Zudem ermöglicht ein Initialisierung-Eingang 658 (Digitaleingang Initialisierung) das Zurücksetzen bzw. das Deaktivieren des Filters, beispielsweise beim Neustart einer Maschine oder noch einem Serviceeinsatz. Die Signalabtastung und die digitale Filterung erfolgt typischerweise in einem Abtastintervall von wenigen Millisekunden. Es sind jedoch auch kürzere Abtastintervalle unter 1 ms denkbar, beispielsweise im Mikrosekundenbereich.

Zusammenfassend ist festzustellen, dass eine Sensorvorrichtung geschaffen wurde, welche eine robuste und zuverlässige Erfassung von ferromagnetischen Werkstücken in Schweissanlagen gewährleistet. Es ist weiterhin festzustellen, dass ein Sensorsystem sowie eine Verfahren geschaffen wurde, welches eine robuste und zuverlässige Überwachung von Werkstücken ermöglicht und welches insbesondere in der Lage ist, automatisch umgebungsbedingte Störeinflüsse zu beseitigen. Zudem ist ein Verfahren geschaffen worden, welches eine automatische Kompensation von umgebungsbedingten Störeinflössen in Schweissanlagen ermöglicht. Schliesslich ist auch eine Schweissanlage geschaffen worden, welche die robuste und zuverlässige Erfassung von ferromagnetischen Werkstücken ermöglicht.

## Patentansprüche

1. Sensorvorrichtung (100, 200, 300, 400, 500) zur Erfassung von ferromagnetischen Werkstücken (103, 203, 403) in einem Detektionsbereich (130, 230) in einer Schweissanlage von Gitterdrähten, umfassend:
a) ein amagnetisches Gehäuse (210, 310);
b) einen Magnetfelderzeuger (106, 206) zur Erzeugung eines Magnetfelds;
c) einen Magnetfeldsensor (107, 207, 307, 507) im Wirkbereich des Magnetfeldes derart ausgestaltet, dass er das lokale Magnetfeld in eine elektrische Grösse umzuwandeln vermag, und
**dadurch gekennzeichnet, dass**
die Sensorvorrichtung (100, 200, 300, 400, 500) mindestens zwei durch den Magnetfelderzeuger (106, 206) entgegengesetzt polarisierte Polplatten (102a, 102b, 202a, 202b, 302a) zur Erhöhung der magnetischen Flussdichte im Detektionsbereich (130, 230) umfasst, wobei der Magnetfelderzeuger (106, 206) und die Polplatten (102a, 102b, 202a, 202b, 302a) so ausgestaltet sind, dass im Detektionsbereich (130, 230) ferromagnetische Werkstücke durch Magnetkraft in eine Sollposition positionierbar sind.

2. Sensorvorrichtung (100, 200, 300, 400, 500) nach Anspruch 1, wobei die Polplatten (102a, 102b, 202a, 202b, 302a) eine erste und eine zweite durch den Magnetfelderzeuger (106, 206) zueinander entgegengesetzt polarisierte Polplatte (102a, 202a, 302a, 102b, 202b) umfassen, die jeweils eine Stirnfläche (101a, 101b, 301) aufweisen, welche zum Detektionsbereich (130, 230) gerichtet und zum Detektionsbereich (130, 230) benachbart ist, und insbesondere wobei die Stirnflächen (101a, 101b, 301) beider Polplatten (102a, 102b, 202a, 202b, 302a) in einer gemeinsamen Ebene angeordnet sind.

3. Sensorvorrichtung (100, 200, 300, 400, 500) nach einem der Ansprüche 1 oder 2, wobei die Polplatten (102a, 102b, 202a, 202b, 302a) einen Zwischenraum (111) definieren und ein erster Bereich des Zwischenraums (111), der bevorzugt benachbart zum Detektionsbereich (130, 230) ist, den Magnetfelderzeuger (106, 206) mindestens teilweise umschliesst, bevorzugt ganz umschliesst, und/oder wobei vorzugsweise ein zweiter, zum ersten Bereich benachbarter, aber vom Detektionsbereich (130, 230) abgewandter Bereich des Zwischenraums (111) den Magnetfeldsensor (107, 207, 307, 507) mindestens teilweise umschliesst, bevorzugt ganz umschliesst.

4. Sensorvorrichtung (100, 200, 300, 400, 500), gemäss einem der vorangehenden Ansprüche, wobei die ferromagnetischen Werkstücke Gitterdrähte sind.

5. Sensorvorrichtung (100, 200, 300, 400, 500) gemäss Anspruch 4, wobei die Stirnflächen (101a, 101b, 301) der Polplatten (102a, 102b, 202a, 202b, 302a) eine Anschlagfläche (104, 404) bilden, insbesondere so dass das ferromagnetische Werkstück (103, 203, 403) in der Sollposition im Wesentlichen einen magnetischen Kurzschluss mit den beiden Polplatten (102a, 102b, 202a, 202b, 302a) herstellt.

6. Sensorvorrichtung (100, 200, 300, 400, 500) nach Anspruch 5, wobei die Sensorvorrichtung (100, 200, 300, 400, 500) so ausgestaltet ist, dass der Magnetfeldsensor (107, 207, 307, 507) den Abstand des ferromagnetischen Werkstücks (103, 203, 403) zur Anschlagfläche (104, 404) zu erfassen vermag.

7. Sensorvorrichtung (100, 200, 300, 400, 500) nach einem der Ansprüche 3 bis 6, weiter umfassend eine amagnetische Verschleissplatte (105, 205), welche im ersten Bereich zwischen dem Magnetfelderzeuger (106, 206) und dem Detektionsbereich (130, 230) angeordnet ist.

8. Sensorvorrichtung (100, 200, 300, 400, 500) nach einem der Ansprüche 1 bis 7, bei welcher die Polplatten (102a, 102b, 202a, 202b, 302a) im Wesentlichen ebenflächig ausgebildet und parallel zueinander angeordnet sind, und der durch den Magnetfelderzeuger (106, 206) definierte magnetische Dipol senkrecht zu den Polplatten (102a, 102b, 202a, 202b, 302a) orientiert ist.

9. Eine Sensorvorrichtung (100, 200, 300, 400, 500) nach einem der vorangehenden Ansprüche, wobei der Magnetfelderzeuger (106, 206) ein Permanentmagnet ist.

10. Eine Sensorvorrichtung (100, 200, 300, 400, 500) nach einem der vorangehenden Ansprüche, bei welcher der Magnetfeldsensor (107, 207, 307, 507) ein Hallsensor ist.

11. Sensorsystem (550) umfassend eine Sensorvorrichtung (100, 200, 300, 400, 500) nach einem der vorangehenden Ansprüche, sowie eine Auswerteelektronik (551) mit mindestens einem analogen Messsignaleingang für die elektrische Grösse des Magnetfeldsensors (107, 207, 307, 507) und mit mindestens einem Ausgang, welcher anzeigen kann, ob ein ferromagnetisches Werkstück (103, 203, 403) in einer Sollposition detektiert wurde, wobei der Ausgang vorzugsweise ein Digitalausgang (555) ist.

12. Sensorsystem (550) nach Anspruch 11, weiter umfassend mindestens einen Signalfilter zur Filterung des analogen Messsignals.

13. Sensorsystem(550) nach Anspruch 12, mit einem Analogausgang (556), derart ausgestaltet, eine physikalische Grösse auszugeben, die in einem Zusammenhang mit der Beschaffenheit des Werkstücks steht, insbesondere einem Durchmesser, wenn es sich beim Werkstück um einen Gitterdraht (103, 203, 403) handelt.

14. Verfahren zur Sollpositionsüberwachung von ferromagnetischen Werkstücken (103, 203, 403) in einem Detektionsbereich (130, 230) einer ferromagnetischen Schweissanlage, insbesondere mit einem Sensorsystem (100, 200, 300, 400, 500) nach einem der Ansprüche 12 oder 13, umfassend die Schritte:
a) Messung des lokalen Magnetfelds im Wirkbereich des Magnetfelds der Sensorvorrichtung (100, 200, 300, 400, 500) durch einen Magnetfeldsensor (107, 207, 307, 507) und Ausgabe eines entsprechenden aktuellen Messwertes;
b) Filterung des aktuellen Messwerts durch einen Signalfilter zur Ermittlung eines gefilterten Messwertes;
c) Verrechnen des aktuellen Messwerts mit dem gefilterten Messwert zur Ermittlung eines kompensierten Messwerts, um Drifteinflüsse durch Umgebungsänderungen zu kompensieren, insbesondere Umgebungsveränderungen durch ferromagnetische Verschmutzungen in Folge des Schweissprozesses;
d) Vergleichen des kompensierten Messwerts mit mindestens einer Überwachungsschwelle;
e) und je nach Über- oder Unterschreiten der Überwachungsschwelle Ausgeben eines Vergleichsergebnisses, welches der Anwesenheit des ferromagnetischen Werkstücks (103, 203, 403) in der Sollposition entspricht.

15. Verfahren nach Anspruch 14, wobei die Filterung eine Tiefpassfilterung ist und das Verrechnen eine Differenzbildung zwischen dem aktuellen Messwert und dem gefilterten Messwert umfasst.

16. Verfahren nach Anspruch 15, umfassend die Schritte der Analog- Digitalumwandlung des Messsignals vor der Filterung und wobei der Filter bei Anwesenheit des ferromagnetischen Werkstücks (103, 203, 403) und/oder durch ein externes digitales Eingangssignal (557, 558) gesteuert, insbesondere während des Schweissprozesses, angehalten wird, um ein Wegdriften der Überwachungsschwelle zu vermeiden.

17. Verfahren nach einem der Ansprüche 14 bis 16, wobei der kompensierte Messwert verwendet wird, um den Drahtdurchmesser zu ermitteln.

18. Gitterschweissanlage mit einer Sensorvorrichtung (100, 200, 300, 400, 500) gemäss einem der Ansprüche 1-10 oder einem Sensorsystem (550) gemäss einem der Ansprüche 11-13.

19. Verwendung einer Sensorvorrichtung (100, 200, 300, 400, 500) gemäss einem der Ansprüche 1-10 oder eines Sensorsystems (550) gemäss einem der Ansprüche 11-13 in einer Schweissanlage für ferromagnetische Werkstücke, insbesondere für Gitterdrähte (103, 203, 403), zur Detektion und Positionierung der ferromagnetischen Werkstücke.

## Claims

1. Sensor device (100, 200, 300, 400, 500) for detecting ferromagnetic workpieces (103, 203, 403) in a detection region (130, 230) in a welding system for grid wires, comprising:
a) a nonmagnetic housing (210, 310);
b) a magnetic field generator (106, 206) for generating a magnetic field;
c) a magnetic field sensor (107, 207, 307, 507) in the active range of the magnetic field, configured in such a way that it is able to convert the local magnetic field into an electrical quantity, and
**characterized in that**
the sensor device (100, 200, 300, 400, 500) comprises at least two pole plates (102a, 102b, 202a, 202b, 302a) polarized oppositely by the magnetic field generator (106, 206) to increase the magnetic flux density in the detection region (130, 230), wherein the magnetic field generator (106, 206) and the pole plates (102a, 102b, 202a, 202b, 302a) are configured in such a way that ferromagnetic workpieces in the detection region (130, 230) can be positioned in a target position by magnetic force.

2. Sensor device (100, 200, 300, 400, 500) according to Claim 1, wherein the pole plates (102a, 102b, 202a, 202b, 302a) comprise a first and a second pole plate (102a, 202a, 302a, 102b, 202b) polarized oppositely to each other by the magnetic field generator (106, 206), which each have an end face (101a, 101b, 301) which is directed towards the detection region (130, 230) and is adjacent to the detection region (130, 230), and in particular wherein the end faces (101a, 101b, 301) of both pole plates (102a, 102b, 202a, 202b, 302a) are arranged in a common plane.

3. Sensor device (100, 200, 300, 400, 500) according to either of Claims 1 and 2, wherein the pole plates (102a, 102b, 202a, 202b, 302a) define an interspace (111), and a first region of the interspace (111), which is preferably adjacent to the detection region (130, 230), encloses the magnetic field generator (106, 206) at least partly, preferably wholly, and/or wherein a second region of the interspace (111), which is preferably adjacent to the first region but faces away from the detection region (130, 230), encloses the magnetic field sensor (107, 207, 307, 507) at least partly, preferably wholly.

4. Sensor device (100, 200, 300, 400, 500) according to one of the preceding claims, wherein the ferromagnetic workpieces are grid wires.

5. Sensor device (100, 200, 300, 400, 500) according to Claim 4, wherein the end faces (101a, 101b, 301) of the pole plates (102a, 102b, 202a, 202b, 302a) form a stop face (104, 404), in particular so that, in the target position, the ferromagnetic workpiece (103, 203, 403) substantially produces a magnetic short-circuit with the two pole plates (102a, 102b, 202a, 202b, 302a).

6. Sensor device (100, 200, 300, 400, 500) according to Claim 5, wherein the sensor device (100, 200, 300, 400, 500) is configured in such a way that the magnetic field sensor (107, 207, 307, 507) is able to detect the distance of the ferromagnetic workpiece (103, 203, 403) from the stop face (104, 404) .

7. Sensor device (100, 200, 300, 400, 500) according to one of Claims 3 to 6, further comprising a nonmagnetic wear plate (105, 205), which is arranged in the first region between the magnetic field generator (106, 206) and the detection region (130, 230) .

8. Sensor device (100, 200, 300, 400, 500) according to one of Claims 1 to 7, in which the pole plates (102a, 102b, 202a, 202b, 302a) are formed so as to be substantially flat and are arranged parallel to each other, and the magnetic dipole defined by the magnetic field generator (106, 206) is oriented at right angles to the pole plates (102a, 102b, 202a, 202b, 302a).

9. A sensor device (100, 200, 300, 400, 500) according to one of the preceding claims, wherein the magnetic field generator (106, 206) is a permanent magnet.

10. A sensor device (100, 200, 300, 400, 500) according to one of the preceding claims, in which the magnetic field sensor (107, 207, 307, 507) is a Hall sensor.

11. Sensor system (550) comprising a sensor device (100, 200, 300, 400, 500) according to one of the preceding claims, and evaluation electronics (551) with at least one analogue measurement signal input for the electrical quantity from the magnetic field sensor (107, 207, 307, 507), and having at least one output which is able to indicate whether a ferromagnetic workpiece (103, 203, 403) has been detected in a target position, wherein the output is preferably a digital output (555).

12. Sensor system (550) according to Claim 11, further comprising at least one signal filter for filtering the analogue measurement signal.

13. Sensor system (550) according to Claim 12, having an analogue output (556), configured in such a way as to output a physical quantity which is related to the nature of the workpiece, in particular a diameter if the workpiece is a grid wire (103, 203, 403).

14. Method for monitoring the target position of ferromagnetic workpieces (103, 203, 403) in a detection region (130, 230) of a ferromagnetic welding system, in particular by using a sensor system (100, 200, 300, 400, 500) according to either of Claims 12 and 13, comprising the steps:
a) measuring the local magnetic field in the active range of the magnetic field of the sensor device (100, 200, 300, 400, 500) by means of a magnetic field sensor (107, 207, 307, 507) and outputting a corresponding current measurement value;
b) filtering the current measurement value by means of a signal filter to determine a filtered measurement value;
c) combining the current measurement value with the filtered measurement value to determine a compensated measurement value in order to compensate for drift influences as a result of environmental changes, in particular environmental changes as a result of ferromagnetic contaminants in the course of the welding process;
d) comparing the compensated measurement value with at least one monitoring threshold;
e) and, depending on whether the monitoring threshold is overshot or undershot, outputting a comparison result which corresponds to the presence of the ferromagnetic workpiece (103, 203, 403) in the target position.

15. Method according to Claim 14, wherein the filtering is low-pass filtering and the combining comprises forming a difference between the current measurement value and the filtered measurement value.

16. Method according to Claim 15, comprising the steps of analogue-digital conversion of the measurement signal before the filtering, and wherein the filter is stopped in the presence of the ferromagnetic workpiece (103, 203, 403) and/or under control of an external digital input signal (557, 558), in particular during the welding process, in order to avoid drifting away from the monitoring threshold.

17. Method according to one of Claims 14 to 16, wherein the compensated measurement value is used to determine the wire diameter.

18. Grid welding system having a sensor device (100, 200, 300, 400, 500) according to one of Claims 1-10 or a sensor system (550) according to one of Claims 11-13.

19. Use of a sensor device (100, 200, 300, 400, 500) according to one of Claims 1-10 or a sensor system (550) according to one of Claims 11-13 in a welding system for ferromagnetic workpieces, in particular for grid wires (103, 203, 403), for the detection and positioning of the ferromagnetic workpieces.

## Revendications

1. Dispositif de détection (100, 200, 300, 400, 500) destiné à détecter des pièces ferromagnétiques (103, 203, 403) dans une zone de détection (130, 230) d'une installation de soudage de fils de treillis, comprenant :
a) un boîtier amagnétique (210, 310) ;
b) un générateur de champ magnétique (106, 206) destiné à générer un champ magnétique ;
c) un capteur de champ magnétique (107, 207, 307, 507) dans la zone d'action du champ magnétique, configuré de manière à convertir le champ magnétique local en une grandeur électrique, et
**caractérisé en ce que** le dispositif de détection (100, 200, 300, 400, 500) comprend au moins deux plaques polaires (102a, 102b, 202a, 202b, 302a) polarisées dans des direction opposées par le générateur de champ magnétique (106, 206) pour augmenter la densité de flux magnétique dans la zone de détection (130, 230), dans lequel le générateur de champ magnétique (106, 206) et les plaques polaires (102a, 102b, 202a, 202b, 302a) sont configurées de manière à ce que des pièces ferromagnétiques puissent être positionnées à une position nominale par une force magnétique dans la zone de détection (130, 230).

2. Dispositif de détection (100, 200, 300, 400, 500) selon la revendication 1, dans lequel les plaques polaires (102a, 102b, 202a, 202b, 302a) comprennent une première et une seconde plaque polaire (102a, 202a, 302a, 102b, 202b) polarisée de manière opposée par le générateur de champ magnétique (106, 206), qui présentent respectivement une face frontale (101a, 101b, 301) dirigée vers la zone de détection (130, 230) et adjacente à la zone de détection (130, 230) et en particulier, dans lequel les faces frontales (101a, 101b, 301) des deux plaques polaires (102a, 102b, 202a, 202b, 302a) sont disposées dans un plan commun.

3. Dispositif de détection (100, 200, 300, 400, 500) selon l'une des revendications 1 ou 2, dans lequel les plaques polaires (102a, 102b, 202a, 202b, 302a) définissent un espace intermédiaire (111) et dans lequel une première zone de l'espace intermédiaire (111), qui est de préférence adjacente à la zone de détection (130, 230), entoure au moins partiellement et de préférence entièrement le générateur de champ magnétique (106, 206), et/ou dans lequel une seconde zone de l'espace intermédiaire (111), qui est adjacente à la première zone mais est tournée en sens opposé à la zone de détection (130, 230), entoure au moins partiellement et de préférence entièrement, le capteur de champ magnétique (107, 207, 307, 507).

4. Dispositif de détection (100, 200, 300, 400, 500) selon l'une des revendications précédentes, dans lequel les pièces ferromagnétiques sont des fils de treillis.

5. Dispositif de détection (100, 200, 300, 400, 500) selon la revendication 4, dans lequel les faces frontales (101a, 101b, 301) des plaques polaires (102a, 102b, 202a, 202b, 302a) forment une surface de butée (104, 404), en particulier de manière à ce que la pièce ferromagnétique (103, 203, 403) produise sensiblement un court-circuit magnétique avec les deux plaques polaires (102a, 102b, 202a, 202b, 302a) à la position nominale.

6. Dispositif de détection (100, 200, 300, 400, 500) selon la revendication 5, dans lequel le dispositif de détection (100, 200, 300, 400, 500) est configuré de manière à ce que le capteur de champ magnétique (107, 207, 307, 507) soit capable de détecter la distance de la pièce ferromagnétique (103, 203, 403) par rapport à la surface de butée (104, 404).

7. Dispositif de détection (100, 200, 300, 400, 500) selon l'une des revendications 3 à 6, comprenant en outre une plaque d'usure amagnétique (105, 205), qui est disposée dans la première zone entre le générateur de champ magnétique (106, 206) et la zone de détection (130, 230).

8. Dispositif de détection (100, 200, 300, 400, 500) selon l'une des revendications 1 à 7, dans lequel les plaques polaires (102a, 102b, 202a, 202b, 302a) sont réalisées de manière sensiblement plane et sont disposées parallèlement l'une à l'autre, et dans lequel le dipôle magnétique défini par le générateur de champ magnétique (106, 206) est orienté perpendiculairement aux plaques polaires (102a, 102b, 202a, 202b, 302a).

9. Dispositif de détection (100, 200, 300, 400, 500) selon l'une des revendications précédentes, dans lequel le générateur de champ magnétique (106, 206) est un aimant permanent.

10. Dispositif de détection (100, 200, 300, 400, 500) selon l'une des revendications précédentes, dans lequel le capteur de champ magnétique (107, 207, 307, 507) est un capteur à effet Hall.

11. Système de détection (550) comprenant un dispositif de détection (100, 200, 300, 400, 500) selon l'une des revendications précédentes, ainsi qu'une électronique d'évaluation (551) comportant au moins une entrée de signal de mesure analogique destinée à la grandeur électrique du capteur magnétique (107, 207, 307, 507) et comportant au moins une sortie qui peut indiquer si une pièce ferromagnétique (103, 203, 403) a été détectée à une position nominale, dans lequel la sortie est de préférence une sortie numérique (555).

12. Système de détection (550) selon la revendication 11, comprenant en outre au moins un filtre de signal destiné à filtrer le signal de mesure analogique.

13. Système de détection (550) selon la revendication 12, comportant une sortie analogique (556) configurée de manière à délivrer une grandeur physique qui est liée à la nature de la pièce, en particulier un diamètre, lorsque la pièce est un fil de treillis (103, 203, 403).

14. Procédé de surveillance de la position nominale de pièces ferromagnétiques (103, 203, 403) dans une zone de détection (130, 230) d'une installation de soudage ferromagnétique, comportant en particulier un système de détection (100, 200, 300, 400, 500) selon l'une des revendications 12 ou 13, comprenant les étapes consistant à :
a) mesurer le champ magnétique local dans la zone d'action du champ magnétique du dispositif de détection (100, 200, 300, 400, 500) au moyen d'un capteur de champ magnétique (107, 207, 307, 507) et délivrer une valeur de mesure actuelle correspondante ;
b) filtrer la valeur de mesure actuelle au moyen d'un filtre de signal pour déterminer une valeur de mesure filtrée ;
c) calculer la valeur de mesure actuelle avec la valeur de mesure filtrée pour déterminer une valeur de mesure compensée afin de compenser des influences liées à la dérive provoquée par des modifications de l'environnement, en particulier des modifications de l'environnement dues à la contamination ferromagnétique résultant du processus de soudage ;
d) comparer la valeur de mesure composée à au moins un seuil de surveillance;
e) et, selon que le seuil de surveillance est franchi en sens croissant ou décroissant, délivrer un résultat de comparaison qui correspond à la présence de la pièce ferromagnétique (103, 203, 403) à la position nominale.

15. Procédé selon la revendication 14, dans lequel le filtrage est un filtrage passe-bas et le calcul comprend un calcul de différence entre la valeur de mesure actuelle et la valeur de mesure filtrée.

16. Procédé selon la revendication 15, comprenant les étapes consistant à effectuer une conversion analogique-numérique du signal de mesure avant le filtrage et dans lequel le filtre est désactivé en présence de la pièce ferromagnétique (103, 203, 403) et/ou en étant commandé par un signal d'entrée numérique externe (557, 558), en particulier pendant le processus de soudage, afin d'éviter une dérive du seuil de surveillance.

17. Procédé selon l'une des revendications 14 à 16, dans lequel la valeur de mesure compensée est utilisée afin de déterminer le diamètre du fil.

18. Installation de soudage de treillis comportant un dispositif de détection (100, 200, 300, 400, 500) selon l'une des revendications 1-10, ou un système de détection (550) selon l'une des revendications 11-13.

19. Utilisation d'un dispositif de détection (100, 200, 300, 400, 500) selon l'une des revendications 1-10, ou d'un système de détection (550) selon l'une des revendications 11-13 dans une installation de soudage de pièces ferromagnétiques, en particulier de fils de treillis (103, 203, 403), pour détecter et positionner les pièces ferromagnétiques.
